# EUROPÄISCHE PATENTSCHRIFT

(11) **EP 2 715 809 B1**
(45) Veröffentlichungstag und Bekanntmachung des Hinweises auf die Patenterteilung: **05.06.2019**
(21) Anmeldenummer: 12724562.9
(22) Anmeldetag: 26.04.2012
(51) Int. Cl.: H01L 33/42, H01L 33/38, H01L 33/20, H01L 33/40

(54) **OPTOELEKTRONISCHER HALBLEITERCHIP**
OPTOELECTRONIC SEMICONDUCTOR CHIP
PUCE SEMICONDUCTRICE OPTOÉLECTRONIQUE

(30) Priorität: 25.05.2011 DE 102011102376; 10.08.2011 DE 102011109942
(43) Veröffentlichungstag der Anmeldung: 09.04.2014
(73) Patentinhaber: OSRAM Opto Semiconductors GmbH, 93055 Regensburg (DE)
(72) Erfinder: MAUTE, Markus, 93087 Alteglofsheim (DE); ENGL, Karl, 93080 Pentling - OT Niedergebraching (DE); TAEGER, Sebastian, 93055 Regensburg (DE); WALTER, Robert, 92331 Parsberg (DE); STOCKER, Johannes, 94136 Thyrnau (DE)
(74) Vertreter: Epping - Hermann - Fischer
(86) Internationale Anmeldenummer: PCT/DE2012/100118
(87) Internationale Veröffentlichungsnummer: WO 2012/159615

(56) Entgegenhaltungen:
- DE-A1-102007 029 370
- DE-A1-102008 011 848
- US-A1- 2009 283 787

## Beschreibung

Die Anmeldung betrifft einen optoelektronischen Halbleiterchip umfassend einen Halbleiterkörper, eine p-Kontaktschicht und eine n-Kontaktschicht.

US 2009/0283787 offenbart einen optoelektronischen Halbleiterchip, der einen Halbleiterkörper aus Halbleitermaterial, eine p-Kontaktschicht und eine n-Kontaktschicht umfasst. Die n-Kontaktschicht enthält eine TCO-Schicht und eine Spiegelschicht, wobei die TCO-Schicht zwischen der n-Seite des Halbleiterkörpers und der Spiegelschicht angeordnet ist.

Als n-Kontaktschicht für beispielsweise einen auf GaN basierenden Halbleiterkörper finden herkömmlicherweise eine Titanschicht und eine darauf aufgebrachte Silberschicht Verwendung. Mit derartigen n-Kontaktschichten können gute elektrische und optische Eigenschaften realisiert werden. Jedoch sind bei derartigen n-Kontaktschichten für gute optische Eigenschaften sehr dünne Titanschichten mit Dicken von kleiner als 0,5 nm notwendig, die nur schwer herstellbar sind und diversen Prozessschwankungen unterliegen.

Zudem weist Titan zwar zu n-GaN einen guten elektrischen Kontakt auf. Jedoch hat Titan eine vergleichsweise schlechte Reflektivität, sodass vom Halbleiterkörper emittiertes Licht von der Titanschicht der n-Kontaktschicht nachteilig absorbiert wird. Dem entgegen ist Silber ein guter Reflektor für Strahlung im sichtbaren Spektralbereich. Jedoch weist Silber nachteilig einen ungünstig hohen Kontaktwiderstand zu n-dotiertem GaN auf. Zusätzlich weisen Titan und die Kombination von Titan und Silber verschiedene physikalische Eigenschaften auf, die für Halbleiterchips nachteilig sein können. Beispielsweise ist Titan sehr reaktiv und kann leicht oxidieren, was aufgrund des Anstiegs des Kontaktwiderstands zu einer schlecht leitenden elektrischen Barriere führen kann.

Es ist Aufgabe der vorliegenden Anmeldung, einen optoelektronischen Halbleiterchip anzugeben, der die oben genannten Nachteile vermeidet, wodurch sich vorteilhafterweise ein Halbleiterchip mit einer n-Kontaktschicht ergibt, die verbesserte elektrische und gleichzeitig optische Eigenschaften aufweist.

Diese Aufgabe wird durch einen optoelektronischen Halbleiterchip mit den Merkmalen des Anspruchs 1 gelöst. Vorteilhafte Weiterbildungen des Halbleiterchips sind Gegenstand der abhängigen Ansprüche.

Erfindungsgemäß weist der optoelektronische Halbleiterchip einen Halbleiterkörper aus Halbleitermaterial, eine p-Kontaktschicht und eine n-Kontaktschicht auf. Der Halbleiterkörper weist eine zur Strahlungserzeugung vorgesehene aktive Schicht auf. Der Halbleiterkörper weist weiter eine p-Seite und eine n-Seite auf, zwischen denen die aktive Schicht angeordnet ist. Die p-Kontaktschicht ist zur elektrischen Kontaktierung der p-Seite des Halbleiterkörpers vorgesehen. Die n-Kontaktschicht ist zur elektrischen Kontaktierung der n-Seite des Halbleiterkörpers vorgesehen. Die n-Kontaktschicht umfasst eine TCO (transparent conductive oxide)-Schicht und eine Spiegelschicht, wobei die TCO-Schicht zwischen der n-Seite des Halbleiterkörpers und der Spiegelschicht angeordnet ist.

Transparente leitende Oxide sind transparente, leitende Materialien, in der Regel Metalloxide, wie beispielsweise Zinkoxid, Zinnoxid, Cadmiumoxid, Titanoxid, Indiumoxid, Indiumzinnoxid (ITO), Aluminiumzinkoxid (AZO), Aluminiumindiumzinkoxid (ATO), Indiumzinkoxid (IZO), Galliumzinkoxid (GZO) oder Galliumzinnoxid (GTO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO3, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Unter n-Seite ist insbesondere eine n-dotierte Seite der Schichten des Halbleiterkörpers zu verstehen. Ebenso ist unter einer p-Seite und eine p-dotierte Seite der Schichten des Halbleiterkörpers zu verstehen.

Im vorliegenden Halbleiterchip ist die herkömmlicherweise verwendete Titanschicht durch eine Schicht aus einem transparenten leitfähigen Oxid ersetzt. Die TCO-Schicht kann dabei eine wesentlich größere Dicke aufweisen als die bisher verwendete Titanschicht. Solche TCO-Schichten lassen sich im Vergleich zu herkömmlicherweise verwendeten Titanschichten wesentlich besser kontrollieren, haften gut und ergeben einen guten elektrischen Kontakt zum Halbleiterkörper aus Halbleitermaterial. Zudem sind derartige TCO-Schichten deutlich weniger reaktiv und damit weniger anfällig auf Oxidation.

Mittels einer n-Kontaktschicht aufweisend eine TCO-Schicht kann, insbesondere in Verbindung mit der auf der dem Halbleiterkörper abgewandten Seite der TCO-Schicht angeordneten hochreflektiven Spiegelschicht der Kontaktschicht, wie einer Silberschicht, ein hochreflektierender ohmscher Kontakt der n-Kontaktschicht zum Halbleiterkörper realisiert werden. Derartige n-Kontaktschichten sind gut reproduzierbar, bei der Herstellung gut kontrollierbar, weisen einen geringeren Kontaktwiderstand auf, sind wenig reaktiv und ermöglichen eine hohe Ausbeute aufgrund eines stabilen Kontaktwiderstands. Aufgrund der Transparenz der TCO-Schicht für Strahlung im sichtbaren Spektralbereich wird vorteilhafterweise vom Halbleiterchip emittierte Strahlung nicht von der n-Kontaktschicht absorbiert, sodass eine verbesserte Strahlungseffizienz ermöglicht wird.

Die Spiegelschicht ist zweckmäßigerweise bezüglich des Materials so ausgebildet, dass sie für im Betrieb des Halbleiterchips in der aktiven Schicht emittierte oder von der aktiven Schicht zu detektierende Strahlung eine hohe Reflektivität, insbesondere eine Reflektivität von mindestens 60 %, bevorzugt eine Reflektivität von mindestens 80 %, aufweist. Insbesondere ist eine metallische Spiegelschicht besonders geeignet.

Erfindungsgemäß enthält die Spiegelschicht Silber. Die Spiegelschicht kann insbesondere aus Silber oder einer Silber-haltigen Legierung bestehen. Silber weist im sichtbaren und ultravioletten Spektralbereich eine hohe Reflektivität auf. Davon abweichend kann auch ein anderes Material Anwendung finden, beispielsweise Aluminium, Rhodium, Palladium, Nickel oder Chrom. Für den infraroten Spektralbereich eignet sich beispielsweise Gold.

Der Halbleiterchip ist vorzugsweise ein optoelektronischer Halbleiterchip, der die Umwandlung von elektrischer Leistung in beispielsweise konstante oder gepulste Lichtemission, etwa zur Datenübertragung, ermöglicht oder umgekehrt. Beispielsweise ist der optoelektronische Halbleiterchip ein strahlungsemittierender Halbleiterchip. Bevorzugt ist der Halbleiterchip eine LED, besonders bevorzugt eine Dünnfilm-LED. Als Dünnfilm-LED wird im Rahmen der Anmeldung eine LED angesehen, während deren Herstellung das Aufwachssubstrat, auf dem der Halbleiterkörper epitaktisch aufgewachsen wurde, vorzugsweise vollständig abgelöst ist.

Die aktive Schicht des Halbleiterkörpers enthält vorzugsweise einen pn-Übergang, eine Doppelheterostruktur, eine Einfachquantentopfstruktur (SQW, single quantum well) oder eine Mehrfachquantentopfstruktur (MQW, multi quantum well) zur Strahlungserzeugung. Die Bezeichnung Quantentopfstruktur entfaltet hierbei keine Bedeutung hinsichtlich der Dimensionalität der Quantisierung. Sie umfasst unter anderem Quantentröge, Quantendrähte und Quantenpunkte und jede Kombination dieser Strukturen.

Der Halbleiterkörper, insbesondere die aktive Schicht, enthält vorzugsweise ein III/V-Halbleitermaterial. III/V-Halbleitermaterialien sind zur Strahlungserzeugung im ultravioletten, über den sichtbaren bis in den infraroten Spektralbereich besonders geeignet. Der Halbleiterkörper weist eine Mehrzahl von aufeinander epitaktisch abgeschiedenen Halbleiterschichten auf, in denen die aktive Schicht angeordnet ist. Beispielsweise sind die Schichten des Halbleiterkörpers auf einem Aufwachssubstrat aufgewachsen. Die aktive Schicht trennt dabei die p-dotierte Seite des Halbleiterkörpers von der n-dotierten Seite des Halbleiterkörpers.

Erfindungsgemäß sind die p-Kontaktschicht und die n-Kontaktschicht auf derselben Seite des Halbleiterkörpers angeordnet. Beispielsweise sind die p-Kontaktschicht und die n-Kontaktschicht auf der p-Seite des Halbleiterkörpers angeordnet. Die den Kontaktschichten gegenüberliegende Seite des Halbleiterchips dient dabei vorzugsweise als Strahlungsaustrittsseite für die im Halbleiterchip erzeugte Strahlung. Aus der Strahlungsaustrittsseite wird vorzugsweise ein großer Anteil der von der aktiven Schicht erzeugten Strahlung aus dem Halbleiterchip ausgekoppelt.

Der Halbleiterchip weist somit vorzugsweise eine einseitige Kontaktierung auf, sodass die Strahlungsaustrittsseite frei von Kontaktstrukturen und Kontaktschichten ist. Dadurch werden vorteilhafterweise Absorptionsprozesse an der Strahlungsaustrittsseite des Halbleiterchips vermieden, sodass mit Vorteil Abschattungseffekte und Effizienzverluste minimiert werden können.

In einer Weiterbildung grenzt die p-Kontaktschicht direkt an die p-Seite des Halbleiterkörpers an, wobei die n-Kontaktschicht an der von dem Halbleiterkörper abgewandten Seite der p-Kontaktschicht angeordnet ist. Zwischen der p-Kontaktschicht und der n-Kontaktschicht ist eine elektrisch isolierende Schicht angeordnet. Die n-Kontaktschicht und die p-Kontaktschicht sind somit voneinander elektrisch isoliert, sodass ein Kurzschluss zwischen den Kontaktschichten verhindert wird.

Im vorliegenden Fall ist die Anordnung somit wie folgt: n-Kontaktschicht, elektrisch isolierende Schicht, p-Kontaktschicht und Halbleiterkörper. Die Schichten sind dabei vertikal übereinander angeordnet.

Die elektrisch isolierende Schicht ist beispielsweise eine Passivierungsschicht, die die p-Kontaktschicht und die n-Kontaktschicht räumlich und elektrisch vollständig voneinander trennt. Die p-Kontaktschicht und die n-Kontaktschicht stehen somit an keiner Stelle in direktem Kontakt.

Erfindungsgemäß ist die n-Kontaktschicht mittels eines Durchbruchs durch die p-Kontaktschicht und durch die p-Seite des Halbleiterkörpers zur n-Seite geführt. Die p-Kontaktschicht und die p-Seite weisen demnach einen Durchbruch auf, in die die n-Kontaktschicht hineinreicht. Der Durchbruch durchstößt dabei die aktive Schicht, sodass die n-Kontaktschicht bis zur n-Seite des Halbleiterkörpers geführt ist. Der Durchbruch führt also durch die p-Seite und die aktive Schicht zur n-Seite, wobei der Durchbruch zusätzlich in die n-Seite hineinragt und vorzugsweise dort endet.

Der Durchbruch weist an den Seitenbereichen die elektrisch isolierende Schicht auf, die die n-Kontaktschicht von der p-Kontaktschicht und der p-Seite des Halbleiterkörpers elektrisch isoliert.

Die p-Kontaktschicht ist demnach direkt an der p-Seite des Halbleiterkörpers angeordnet und zur direkten elektrischen Kontaktierung der p-Seite vorgesehen. Die n-Kontaktschicht ist in einem Abstand zum Halbleiterkörper angeordnet. Der Abstand wird durch die p-Kontaktschicht und die elektrisch isolierende Schicht gebildet. Durch den Durchbruch kann die n-Seite des Halbleiterkörpers mittels der n-Kontaktschicht elektrisch kontaktiert werden.

Der Halbleiterchip kann auch eine Mehrzahl von Durchbrüchen aufweisen, durch die jeweils die n-Kontaktschicht geführt ist. Die Durchbrüche sind dabei voneinander beabstandet angeordnet. Die Anordnung der Durchbrüche ist so ausgebildet, dass eine möglichst homogene Bestromung der n-Seite des Halbleiterkörpers realisiert wird, sodass eine homogene Strahlungserzeugung in der aktiven Schicht gewährleistet wird.

Erfindungsgemäß enthält die n-Kontaktschicht eine Silberschicht, wobei die TCO-Schicht der n-Kontaktschicht zwischen der n-Seite des Halbleiterkörpers und der Silberschicht der n-Kontaktschicht angeordnet ist. Die n-Kontaktschicht setzt sich demnach aus zwei Schichten zusammen, die Silberschicht und die TCO-Schicht. Die Silberschicht bildet dabei die Spiegelschicht, die ein guter Reflektor für Strahlung im sichtbaren Spektralbereich ist.

Der hohe Kontaktwiderstand der Silberschicht zum Halbleitermaterial des Halbleiterkörpers kann mittels der TCO-Schicht verbessert werden, sodass ein hochreflektierender ohmscher Kontakt der n-Kontaktschicht realisiert wird. Beispielsweise ist die Spiegelschicht auf der von dem Halbleiterkörper abgewandten Seite der elektrisch isolierenden Schicht und in den Durchbrüchen angeordnet. Die TCO-Schicht trennt dabei die Spiegelschicht, insbesondere die Silberschicht, vom Halbleiterkörper, ist also zwischen Spiegelschicht, insbesondere Silberschicht, und Halbleiterkörper angeordnet. Insbesondere grenzt die TCO-Schicht direkt an das Halbleitermaterial und an die Spiegelschicht, insbesondere die Silberschicht, an.

In einer Weiterbildung ist die Spiegelschicht, insbesondere die Silberschicht, durch den Durchbruch geführt und die TCO-Schicht auf dem Durchbruch angeordnet. Zwischen Spiegelschicht, insbesondere Silberschicht, und Halbleitermaterial wird demnach kein direkter Kontakt ausgebildet, da dazwischen die TCO-Schicht angeordnet ist. Die TCO-Schicht schließt dabei den Durchbruch ab.

In einer Weiterbildung enthält die TCO-Schicht ZnO (Zinkoxid) oder SnO (Zinnoxid). Die TCO-Schicht kann zusätzlich mit einem weiteren Metall oder einer Mischung mit weiteren Metallen versetzt sein, etwa mit Aluminium, Gallium und/oder Indium. Beispielsweise kann Aluminiumzinkoxid, Aluminiumzinnoxid, Galliumzinnoxid, Galliumzinkoxid, Indiumzinnoxid oder Indiumzinkoxid Anwendung finden. Diese Materialien zeichnen sich durch eine geringe Absorption im sichtbaren Spektralbereich und demnach durch eine hohe Transparenz für Strahlung im sichtbaren Spektralbereich aus. Zudem weisen diese Materialien einen geringen Kontaktwiderstand zum Halbleitermaterial auf, sodass ein guter ohmscher Kontakt realisiert wird.

In einer Weiterbildung weist die TCO-Schicht eine Dicke von größer als 0,5 nm auf. Vorzugsweise weist die TCO-Schicht eine Dicke in einem Bereich zwischen einschließlich 15 nm und einschließlich 25 nm auf. Kontaktschichten in einem derartigen Dickenbereich unterliegen bei der Herstellung mit Vorteil geringen Prozessschwankungen. Zudem sind Schichten mit derartigen Dicken aufgrund der kontrollierbaren Herstellung gut reproduzierbar.

In einer Weiterbildung weist der Halbleiterkörper schräge Seitenflächen auf. Beispielsweise ist der Halbleiterkörper auf einem Träger angeordnet, wobei sich die laterale Ausdehnung des Halbleiterkörpers mit Abstand zum Träger verjüngt. Der Winkel zwischen lateraler Ausdehnung des Trägers und schrägen Seitenflächen beträgt beispielsweise 45°.

Durch die schrägen Seitenflächen können vorteilhafterweise Totalreflexionseffekte der von der aktiven Schicht emittierten Strahlung an den Seitenflächen reduziert werden, sodass sich vorteilhafterweise die Auskoppeleffizienz des Halbleiterchips erhöht.

In einer Weiterbildung basiert der Halbleiterkörper auf GaN. N-dotiertes GaN weist zu TCO einen guten elektrischen Kontakt auf, wobei mit der n-Kontaktschicht aus der Kombination von TCO und Silber zum Halbleiterkörper aus GaN ein hochreflektierender ohmscher Kontakt realisiert werden kann.

Weitere Vorteile und vorteilhafte Weiterbildungen ergeben sich aus den im Folgenden in Verbindung mit den Figuren 1 bis 3 beschriebenen Ausführungsbeispielen. Es zeigen:
- Figur 1: einen schematischen Querschnitt eines Ausführungsbeispiels eines Halbleiterchips,
- Figur 2: einen schematischen Ausschnitt des Halbleiterchips gemäß dem Ausführungsbeispiel der Figur 1, und
- Figur 3: einen schematischen Ausschnitt der n-Kontaktschicht gemäß dem Stand der Technik.

In den Figuren können gleiche oder gleich wirkende Bestandteile jeweils mit den gleichen Bezugszeichen versehen sein. Die dargestellten Bestandteile und deren Größenverhältnisse untereinander sind nicht als maßstabsgerecht anzusehen. Vielmehr können einzelne Bestandteile, wie beispielsweise Schichten, Strukturen, Komponenten und Bereiche zur besseren Darstellbarkeit und/oder zum besseren Verständnis übertrieben dick oder groß dimensioniert dargestellt sein.

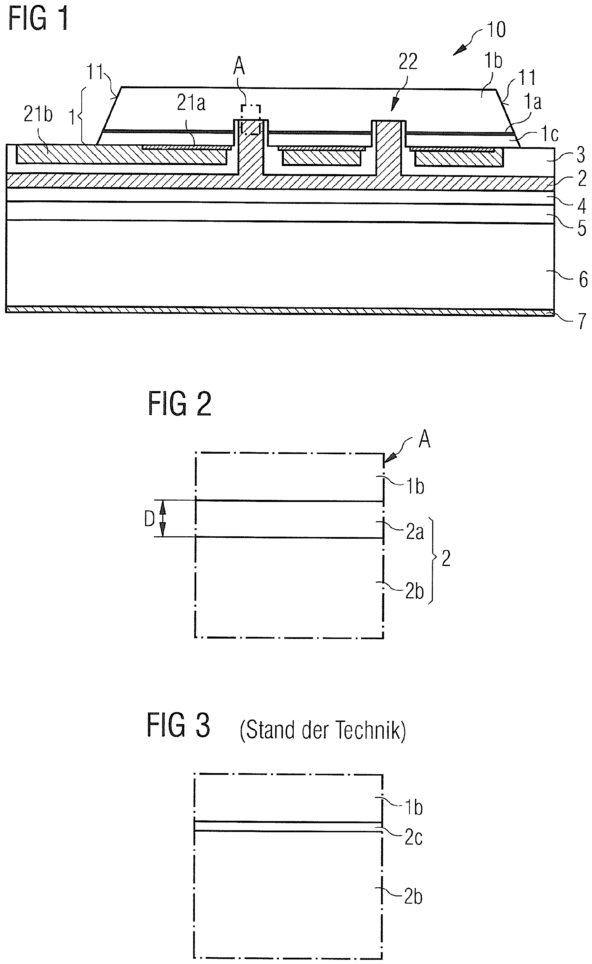

In Figur 3 ist ein Querschnitt eines Ausschnitts eines Halbleiterchips gemäß dem Stand der Technik dargestellt. Der Ausschnitt zeigt insbesondere die n-Kontaktierung des Halbleiterchips. Der Halbleiterchip weist eine n-Seite 1b auf, die aus Halbleiterschichten gebildet ist. Um die n-Seite des Halbleiterchips zu kontaktieren, findet eine n-Kontaktschicht 2b, 2c Verwendung. Die n-Kontaktschicht ist zusammengesetzt aus einer Silberschicht 2b und einer Titanschicht 2c, wobei die Titanschicht 2c zwischen n-Seite 1b des Halbleiterchips und Silberschicht 2b angeordnet ist.

Die Silberschicht 2b steht demnach nicht in direktem Kontakt mit der n-Seite des Halbleiterchips. Die Titanschicht 2c erzeugt einen guten elektrischen Kontakt zur n-Seite 1b des Halbleiterchips. Derartige Titanschichten 2c weisen jedoch eine schlechte Reflektivität der Strahlung im sichtbaren Spektralbereich auf, sodass die Strahlung zumindest teilweise von der Titanschicht absorbiert wird, was nachteilig zu einem Strahlungseffizienzverlust führt. Zudem ist die Titanschicht 2c nachteilig sehr reaktiv und leicht oxidierbar.

Die Silberschicht 2b ist ein guter Reflektor für Strahlung im sichtbaren Spektralbereich, weist aber einen ungünstig hohen Kontaktwiderstand zur n-Seite 1b des Halbleiterchips auf.

Die Titanschicht 2c ist aufgrund der absorbierenden Eigenschaften herkömmlicherweise sehr dünn ausgebildet. Beispielsweise weist eine derartige Titanschicht 2c eine Dicke von höchstens 0,5 nm auf.

Derartige herkömmlich verwendete n-Kontaktschichten umfassend eine Titanschicht 2c und eine Silberschicht 2b weisen demnach eine Mehrzahl von Nachteilen auf, wie beispielsweise Absorptionseffekte, nachteilige Oxidationsbereitschaft sowie ungünstige Kontaktwiderstände.

Um eine n-Kontaktschicht zu realisieren, die diese Nachteile vermeidet, wird die herkömmlich verwendete Titanschicht ersetzt durch eine TCO-Schicht. Die TCO-Schicht mit einer dahinter angeordneten Silberschicht weist eine geringe Absorption bei gleichzeitig guter Reflektivität für Strahlung im sichtbaren Spektralbereich auf. Solche TCO-Schichten lassen sich zudem wesentlich besser kontrollieren als herkömmliche Titanschichten, haften gut, ergeben einen guten elektrischen Kontakt und sind deutlich weniger reaktiv.

In Figur 1 ist ein schematischer Querschnitt eines Halbleiterchips 10 gezeigt, der einen Halbleiterkörper 1 aufweist. Der Halbleiterkörper 1 weist eine n-Seite 1b, eine p-Seite 1c und eine aktive Schicht 1a auf, die zwischen n-Seite 1b und p-Seite 1c angeordnet ist. Der Halbleiterkörper basiert vorzugsweise auf GaN. Beispielsweise ist der Halbleiterkörper 1 ein strahlungsemittierender Halbleiterchip, vorzugsweise eine LED, besonders bevorzugt eine Dünnfilm-LED.

Der Halbleiterkörper 1 weist schräge Seitenflächen 11 auf. Unter schrägen Seitenflächen ist insbesondere zu verstehen, dass die Seitenflächen in einem Winkel zwischen 0 und 90° zur lateralen Ausdehnung der Schichten des Halbleiterkörpers ausgebildet sind. Vorzugsweise liegt der Winkel zwischen 45° und 90°. Durch die schrägen Seitenflächen 11 kann vorteilhafterweise die Auskoppeleffizienz der von der aktiven Schicht emittierten Strahlung verbessert werden, da Totalreflexionseffekte vermindert werden.

Der Halbleiterkörper 1 weist zur p-Kontaktierung eine p-Kontaktschicht 21a und zur n-Kontaktierung eine n-Kontaktschicht 2 auf. Die p-Kontaktschicht 21a ist zur elektrischen Kontaktierung der p-Seite 1c des Halbleiterkörpers 1 vorgesehen. Die n-Kontaktschicht 2 ist zur elektrischen Kontaktierung der n-Seite 1b des Halbleiterkörpers 1 vorgesehen.

Im vorliegenden Ausführungsbeispiel sind die p-Kontaktschicht 21a und die n-Kontaktschicht 2 auf derselben Seite des Halbleiterkörpers 1 angeordnet. Insbesondere sind die Kontaktschichten 21a, 2 auf der p-Seite 1c des Halbleiterkörpers 1 angeordnet. Die p-Kontaktschicht 21a grenzt dabei direkt an die p-Seite 1c des Halbleiterkörpers 1 an. Auf der von dem Halbleiterkörper 1 abgewandten Seite der p-Kontaktschicht 21a kann eine Stromaufweitungsschicht 21b angeordnet sein, die eine homogene Stromführung und Stromaufweitung auf der p-Seite 1c des Halbleiterkörpers 1 ermöglicht.

Auf der von dem Halbleiterkörper 1 abgewandten Seite der p-Kontaktschicht 21a und der Stromaufweitungsschicht 21b ist eine elektrisch isolierende Schicht 3 angeordnet. Die elektrisch isolierende Schicht ist beispielsweise eine Passivierungsschicht. Auf der von der p-Kontaktschicht 21a abgewandten Seite der elektrisch isolierenden Schicht 3 ist die n-Kontaktschicht 2 angeordnet. Die elektrisch isolierende Schicht 3 trennt dabei die p-Kontaktschicht 21a vollständig von der n-Kontaktschicht 2. Die elektrisch isolierende Schicht 3 ist somit zwischen p-Kontaktschicht 21a und n-Kontaktschicht 2 angeordnet.

Die n-Kontaktschicht 2 ist mittels eines Durchbruchs 22 durch die p-Kontaktschicht 21a und durch die p-Seite 1c des Halbleiterkörpers 1 zur n-Seite 1b des Halbleiterchips geführt. Der Durchbruch 22 erstreckt sich dabei durch die p-Kontaktschicht 21a, die p-Seite 1c und die aktive Schicht 1a und endet in der n-Seite 1b des Halbleiterkörpers 1. Die n-Kontaktschicht 21a, die p-Seite 1c und die aktive Schicht 1a werden dabei vollständig von dem Durchbruch 22 durchbrochen.

Der Halbleiterchip 10 kann auch eine Mehrzahl von Durchbrüchen 22 aufweisen, die entsprechend der gewünschten Stromeinprägung in der n-Seite 1b des Halbleiterkörpers 1 angeordnet sind.

Die n-Kontaktschicht 2 enthält eine als Silberschicht ausgeführte Spiegelschicht und eine TCO-Schicht, wobei die Silberschicht auf der von der p-Kontaktschicht 21a abgewandten Seite der elektrisch isolierenden Schicht 3 und in dem Durchbruch 22 oder den Durchbrüchen angeordnet ist. Die TCO-Schicht der n-Kontaktschicht 2 ist zwischen Silberschicht und Halbleitermaterial der n-Seite 1b des Halbleiterkörpers 1 angeordnet. Insbesondere ist die TCO-Schicht auf dem Durchbruch 22 angeordnet.

Die TCO-Schicht ist in Figur 1 der Übersicht halber nicht gezeigt. Der n-Kontakt der n-Kontaktschicht 2 zur n-Seite 1b des Halbleiterkörpers 1 ist jedoch in Figur 2 näher dargestellt und erläutert.

Zur elektrischen Isolierung ist der Durchbruch 22 oder sind die Durchbrüche mit der elektrisch isolierenden Schicht 3 ausgekleidet, sodass die n-Kontaktschicht 2 und die p-Kontaktschicht 21a sowie die p-Seite 1c sich an keiner Stelle direkt berühren beziehungsweise einen elektrischen Kontakt zueinander bilden.

Die elektrische Kontaktierung des Halbleiterchips 1 erfolgt somit einseitig auf der p-Seite des Halbleiterkörpers 1. Auf der der p-Seite 1c gegenüberliegenden Seite des Halbleiterkörpers 1 ist eine Strahlungsaustrittsseite gebildet, durch die die von der aktiven Schicht emittierte Strahlung zum größten Teil aus dem Halbleiterchip 10 ausgekoppelt wird. Auf der von dem Halbleiterkörper 1 abgewandten Seite der n-Kontaktschicht 2 ist eine Barriereschicht 4 angeordnet, die eine Ionendiffusion zwischen einzelnen Schichten des Halbleiterchips 10 verhindert.

Auf der von der n-Kontaktschicht 2 abgewandten Seite der Barriereschicht 4 ist eine Lotschicht 5 angeordnet, mittels der der Halbleiterchip 10 auf einem Träger 6 aufgebracht und befestigt ist. Der Träger 6 weist auf der von dem Halbleiterkörper 1 abgewandten Seite eine elektrische Anschlussschicht 7 auf, durch die der elektrische Anschluss zur n-Kontaktschicht 2 hergestellt werden kann.

Der in dem Ausführungsbeispiel der Figur 1 aufgezeigte Ausschnitt A ist in Figur 2 vergrößert dargestellt. Figur 2 zeigt insbesondere den elektrischen Anschluss zwischen n-Seite 1b des Halbleiterkörpers 1 und n-Kontaktschicht 2. Der Ausschnitt befindet sich im Bereich eines Durchbruchs 22.

Der n-Kontakt zwischen der n-Seite 1b des Halbleiterkörpers 1 und der n-Kontaktschicht 2 wird über die TCO-Schicht 2a gebildet. Die n-Kontaktschicht 2 setzt sich somit aus der Silberschicht 2b und der TCO-Schicht 2a zusammen, wobei die Silberschicht 2b nicht in direktem Kontakt mit dem Halbleitermaterial ist. Zwischen Silberschicht 2b und Halbleitermaterial der n-Seite 1b ist die TCO-Schicht 2a angeordnet.

Die TCO-Schicht 2a weist beispielsweise ZnO oder ITO auf. Alternativ oder ergänzend kann beispielsweise Zinnoxid, Aluminiumzinkoxid, Aluminiumzinnoxid, Galliumzinnoxid, Galliumzinkoxid oder Indiumzinkoxid Anwendung finden. Die Dicke D der TCO-Schicht 2a ist dabei größer als 0,5 nm. Bevorzugt liegt die Dicke D der TCO-Schicht 2a in einem Bereich zwischen einschließlich 15 nm und einschließlich 25 nm, beispielsweise bei 20 nm.

Die herkömmlicherweise verwendete dünne Titanschicht mit einer Dicke von höchstens 0,5 nm wird somit durch eine wesentlich dickere Schicht von einem transparenten leitfähigen Oxid ersetzt, das zusammen mit der dahinter angeordneten Silberschicht eine verbesserte Reflektivität und einen verbesserten ohmschen Kontakt ermöglicht. Solche dicken TCO-Schichten lassen sich wesentlich besser kontrollieren als die herkömmlicherweise verwendeten dünnen Titanschichten. Zudem haften die TCO-Schichten mit Vorteil gut, ergeben einen guten elektrischen Kontakt und sind deutlich weniger reaktiv als die herkömmliche Titanschicht.

Mittels der wie beschrieben ausgebildeten n-Kontaktschicht bestehend aus einer Silberschicht und einer TCO-Schicht kann mit Vorteil auf der n-Seite des Halbleiterchips ein hochreflektierender ohmscher Kontakt gewährleistet werden. Von dem beschriebenen Ausführungsbeispiel abweichend kann anstelle der Silberschicht 3b auch eine Spiegelschicht mit einer anderen Materialzusammensetzung Anwendung finden. Insbesondere kann die vorzugsweise metallische Spiegelschicht eines der im allgemeinen Teil im Zusammenhang mit der Spiegelschicht genannten Materialien enthalten oder aus einem solchen Material bestehen.

Weiterhin eignet sich die beschriebene n-Kontaktschicht auch für die Kontaktierung einer n-Seite eines Halbleiterchips in einer anderen Geometrie. Beispielsweise kann der Halbleiterchip als ein Halbleiterchip ausgeführt sein, bei dem die p-Kontaktschicht und die n-Kontaktschicht auf gegenüberliegenden Seiten der aktiven Schicht angeordnet sind. Ein solcher Halbleiterchip kann insbesondere als ein Dünnfilm-Halbleiterchip oder als ein Halbleiterchip mit Aufwachssubstrat ausgeführt sein.

Die Erfindung ist nicht durch die Beschreibung anhand der Ausführungsbeispiele auf diese beschränkt, sondern wird durch die Ansprüche definiert.

## Patentansprüche

1. Optoelektronischer Halbleiterchip (10) umfassend einen Halbleiterkörper (1) aus Halbleitermaterial, eine p-Kontaktschicht (21a) und eine n-Kontaktschicht (2), wobei
- der Halbleiterkörper (1) eine zur Strahlungserzeugung vorgesehene aktive Schicht (1a) aufweist,
- der Halbleiterkörper (1) eine p-Seite (1c) und eine n-Seite (1b) aufweist, zwischen denen die aktive Schicht (1a) angeordnet ist,
- die p-Kontaktschicht (21a) zur elektrischen Kontaktierung der p-Seite (1c) des Halbleiterkörpers (1) vorgesehen ist,
- die n-Kontaktschicht (2) zur elektrischen Kontaktierung der n-Seite (1b) des Halbleiterkörpers (1) vorgesehen ist,
- die p-Kontaktschicht (21a) und die n-Kontaktschicht (2) auf derselben Seite des Halbleiterkörpers (1) angeordnet sind,
- die n-Kontaktschicht (2) mittels eines Durchbruchs (22) durch die p-Seite (1c) geführt ist und in der n-Seite (1b) des Halbleiterkörpers endet,
- die n-Kontaktschicht (2) eine TCO-Schicht (2a) und eine Spiegelschicht (2b) enthält, und
- die TCO-Schicht (2a) im Durchbruch (22) zwischen der n-Seite (1b) des Halbleiterkörpers (1) und der Spiegelschicht (2b) angeordnet ist,
**dadurch gekennzeichnet, dass**
- die Spiegelschicht (2b) Silber enthält.

2. Optoelektronischer Halbleiterchip nach Anspruch 1, wobei
- die n-Kontaktschicht (2) mittels einer Mehrzahl von Durchbrüchen (22) durch die p-Kontaktschicht (21a) und durch die p-Seite (1c) des Halbleiterkörpers (1) zur n-Seite (1b) geführt ist, und
- die TCO-Schicht (2a) in den Durchbrüchen (22) zwischen der n-Seite (1b) des Halbleiterkörpers (1) und der Spiegelschicht (2b) angeordnet ist.

3. Optoelektronischer Halbleiterchip nach Anspruch 1 oder 2, wobei
- die p-Kontaktschicht (21a) direkt an die p-Seite (1c) des Halbleiterkörpers (1) angrenzt,
- die n-Kontaktschicht (2) an der von dem Halbleiterkörper (1) abgewandten Seite der p-Kontaktschicht (21a) angeordnet ist, und
- zwischen der p-Kontaktschicht (21a) und der n-Kontaktschicht (2) eine elektrisch isolierende Schicht (3) angeordnet ist.

4. Optoelektronischer Halbleiterchip nach einem der vorhergehenden Ansprüche, wobei
- die Spiegelschicht (2b) durch den Durchbruch (22) geführt ist.

5. Optoelektronischer Halbleiterchip nach einem der vorhergehenden Ansprüche, wobei die TCO-Schicht (2a) ZnO oder ITO enthält.

6. Optoelektronischer Halbleiterchip nach einem der vorhergehenden Ansprüche, wobei die TCO-Schicht (2a) eine Dicke von größer als 0,5 nm aufweist.

7. Optoelektronischer Halbleiterchip nach Anspruch 6, wobei die TCO-Schicht (2a) eine Dicke in einem Bereich zwischen einschließlich 15 nm und einschließlich 25 nm aufweist.

8. Optoelektronischer Halbleiterchip nach einem der vorhergehenden Ansprüche, wobei der Halbleiterkörper (1) schräge Seitenflächen (11) aufweist.

9. Optoelektronischer Halbleiterchip nach einem der vorhergehenden Ansprüche, wobei der Halbleiterkörper (1) auf GaN basiert.

## Claims

1. An optoelectronic semiconductor chip (10) comprising a semiconductor body (1) made of semiconductor material, a p-contact layer (21a) and an n-contact layer (2), wherein
- the semiconductor body (1) has an active layer (1a) provided for generating radiation,
- the semiconductor body (1) has a p-side (1c) and an n-side (1B) between which the active layer (1a) is arranged,
- the p-contact layer (21a) is provided for electrically contacting the p-side (1c) of the semiconductor body (1),
- the n-contact layer (2) is provided for electrically contacting the n-side (1b) of the semiconductor body (1),
- the p-contact layer (21a) and the n-contact layer (2) are arranged on the same side of the semiconductor body (1),
- the n-contact layer (2) is formed by means of an opening (22) through the p-side (1C) and ends in the n-side (1b) of the semiconductor body,
- the n-contact layer (2) contains a TCO layer (2a) and a mirror layer (2b), and
- the TCO layer (2a) is arranged in the aperture (22) between the n-side (1b) of the semiconductor body and the mirror layer (2b),
**characterized in that**
- the mirror layer (2b) contains silver.

2. The optoelectronic semiconductor chip according to claim 1, wherein
- the n-contact layer (2) is formed by means of a plurality of apertures (22) through the p-contact layer (21a) and through the p-side (1c) of the semiconductor body to the n-side (1b),
and
- in the openings (22) the TCO layer (2a) is located between the n-side (1B) of the semiconductor body and the mirror layer (2b) .

3. The optoelectronic semiconductor chip according to claim 1 or 2, wherein
- the p-contact layer (21a) directly adjoins the p-side (1c) of the semiconductor body (1),
- the n-contact layer (2) is arranged on the side facing away from the semiconductor body (1) of the p-contact layer (21a), and
- an electrically insulating layer (3) is arranged between the p-contact layer (21a) and the n-contact layer (2).

4. The optoelectronic semiconductor chip according to one of the preceding claims, wherein
- the mirror layer (2b) is guided through the aperture.

5. The optoelectronic semiconductor chip according to one of the preceding claims, wherein
the TCO layer (2a) contains ZnO or ITO.

6. The optoelectronic semiconductor chip according to one of the preceding claims, wherein
the TCO layer (2a) has a thickness of greater than 0.5 nm.

7. The optoelectronic semiconductor chip according to claim 6, wherein
the TCO layer (2a) has a thickness in a range between 15 nm and 25 nm inclusive.

8. The optoelectronic semiconductor chip according to one of the preceding claims, wherein
the semiconductor body (1) has oblique side surfaces (11).

9. The optoelectronic semiconductor chip according to one of the preceding claims, wherein
the semiconductor body is based on GaN.

## Revendications

1. Puce optoélectronique à semiconducteur (10) comportant un corps de semiconducteur (1) en matériau de semiconducteur, une couche de contact p (21a) et une couche de contact n (2), sachant que
- le corps de semiconducteur (1) présente une couche active (1a) prévue pour la génération de rayonnement,
- le corps de semiconducteur (1) présente un côté p (1c) et un côté n (1b), entre lesquels est disposée la couche active (1a),
- la couche de contact p (21a) est prévue pour la mise en contact électrique du côté p (1c) du corps de semiconducteur (1),
- la couche de contact n (2) est prévue pour la mise en contact électrique du côté n (1b) du corps de semiconducteur (1),
- la couche de contact p (21a) et la couche de contact n (2) sont disposées sur le même côté du corps de semiconducteur (1),
- la couche de contact n (2) est guidée au moyen d'un percement (22) à travers le côté p (1c) et se termine dans le côté n (1b) du corps de semiconducteur,
- la couche de contact n (2) contient une couche TCO (2a) et une couche miroir (2b), et
- la couche TCO (2a) est disposée dans le percement (22) entre le côté n (1b) du corps de semiconducteur (1) et la couche miroir (2b),
**caractérisée en ce que**
- la couche miroir (2b) contient de l'argent.

2. Puce optoélectronique à semiconducteur selon la revendication 1, sachant que
- la couche de contact n (2) est guidée au moyen d'une pluralité de percements (22) à travers la couche de contact p (21a) et à travers le côté p (1c) du corps de semiconducteur (1) vers le côté n (1b), et que
- la couche TCO (2a) est disposée dans les percements (22) entre le côté n (1b) du corps de semiconducteur (1) et la couche miroir (2b).

3. Puce optoélectronique à semiconducteur selon la revendication 1 ou 2,
sachant que
- la couche de contact p (21a) est directement adjacente au côté p (1c) du corps de semiconducteur (1),
- la couche de contact n (2) est disposée sur le côté détourné du corps de semiconducteur (1) de la couche de contact p (21a), et
- entre la couche de contact p (21a) et la couche de contact n (2) est disposée une couche électrique isolante (3).

4. Puce optoélectronique à semiconducteur selon une quelconque des revendications précédentes, sachant que
- la couche miroir (2b) est guidée à travers le percement (22).

5. Puce optoélectronique à semiconducteur selon une quelconque des revendications précédentes, sachant que la couche TCO (2a) comporte du ZnO ou de l'ITO.

6. Puce optoélectronique à semiconducteur selon une quelconque des revendications précédentes, sachant que la couche TCO (2a) présente une épaisseur supérieure à 0,5 nm.

7. Puce optoélectronique à semiconducteur selon la revendication 6, sachant que
la couche TCO (2a) présente une épaisseur comprise entre 15 nm inclus et 25 nm inclus dans une zone.

8. Puce optoélectronique à semiconducteur selon une quelconque des revendications précédentes, sachant que le corps de semiconducteur (1) présente des surfaces latérales (11) en biais.

9. Puce optoélectronique à semiconducteur selon une quelconque des revendications précédentes, sachant que le corps de semiconducteur (1) se base sur du GaN.
